# EUROPÄISCHE PATENTSCHRIFT

(11) **EP 2 818 031 B1**
(45) Veröffentlichungstag und Bekanntmachung des Hinweises auf die Patenterteilung: **14.09.2016**
(21) Anmeldenummer: 13705918.4
(22) Anmeldetag: 18.02.2013
(51) Int. Cl.: H05K 1/16, H01F 27/28, H01F 27/32

(54) **PLANARER ÜBERTRAGER**
PLANAR TRANSCEIVER
TRANSFORMATEUR PLANAIRE

(30) Priorität: 22.02.2012 DE 102012003364
(43) Veröffentlichungstag der Anmeldung: 31.12.2014
(73) Patentinhaber: Phoenix Contact GmbH & Co. KG, 32825 Blomberg (DE)
(72) Erfinder: SCHOLZ, Peter, 32683 Barntrup (DE)
(74) Vertreter: Blumbach Zinngrebe
(86) Internationale Anmeldenummer: PCT/EP2013/000472
(87) Internationale Veröffentlichungsnummer: WO 2013/124049

(56) Entgegenhaltungen:
- WO-A1-2004/040599
- DE-U1- 29 611 276
- GB-A- 2 355 343
- US-A- 5 353 001

## Beschreibung

Die vorliegende Erfindung bezieht sich allgemein auf das Gebiet der Interfacetechnik mit elektronischen Bauelementen, die für Mess-, Steuer- und Regelungsaufgaben, insbesondere als Trennverstärker, eingesetzt werden können. Diese Trennverstärker stellen eine galvanische Trennung zwischen einem Primärkreis und einem Sekundärkreis bereit und sind beispielsweise für einen eigensicheren Betrieb geeignet.

Die vorliegende Erfindung betrifft einen Übertrager, insbesondere einen planaren, nicht störanfälligen Übertrager, der für eigensichere Stromkreise geeignet ist und im Folgenden als planarer eigensicherer Übertrager bezeichnet wird.

Eigensichere Übertrager oder Transformatoren werden zur galvanischen Trennung von Stromkreisen nach verschiedenen Normen eingesetzt, wobei über die Übertrager sowohl Energie als auch Signale und/oder Daten übertragen werden können.

In verschiedenen Vorschriften und Normen, beispielsweise DIN EN 60079-11, sind für verschiedene Sicherheitsklassen von Betriebsmitteln Mindestabstände für die Trennung der Stromkreise und somit auch der Windungen oder Wicklungen der Transformatoren vorgegeben. Diese Mindestabstände sind vom Isoliermedium abhängig, so dass die Mindestabstände in Feststoffisolierung, Luft- und Kriechstrecken unterteilt sind. In einer typischen Isolationsklasse, beispielsweise Schutzniveau 375 V, beträgt der minimale Trennabstand bei fester Isolierung beispielsweise 1 mm, die Kriechstrecke in Luft 10 mm und die Kriechstrecke unter einer Schutzschicht etwa 3,3 mm.

Eigensichere Übertrager sind hinsichtlich der Geometrie derart ausgelegt und optimiert, dass die benötigten Trennabstände für ein bestimmtes Schutzniveau sichergestellt werden. Dies kann sowohl durch gewickelte Spulen als auch durch gedruckte oder geätzte Spulen auf Leiterplatten gewährleistet werden. Dabei ist bei gedruckten oder geätzten Spulen von Vorteil, dass keine zusätzlichen Wicklungsprozesse benötigt werden und eine gute Reproduzierbarkeit gewährleistet werden kann. Weitere Vorteile können in einer verbesserten thermischen Eigenschaft bei gleichem Kernvolumen liegen. Ferner können Herstellungskosten geringer ausfallen.

DE 10 2005 041 131 A1 offenbart einen eigensicheren Übertrager mit gewickelten Spulen, wobei die Wicklungen der Spulen aufgrund von geforderten Isolierungsabständen auf verschiedenen Ringkernen angebracht sind, die über eine zusätzliche in eine Leiterplatte eingelassene Windung magnetisch miteinander gekoppelt sind. Der so ausgebildete Übertrager basiert auf klassischer Wicklungstechnik kombiniert mit einer Leiterplattentechnologie, wobei die Leiterplatte sowohl zur Isolierung als auch zur mechanischen Fixierung verwendet wird.

In US 2011/0140824 A1 wird ein Übertrager vorgeschlagen, bei dem die zu isolierenden Stromkreise bzw. Windungen asymmetrisch auf verschiedenen Leiterplatten angebracht sind, die anschließend übereinander mit einem magnetischen Kern zu einem Transformator bzw. Übertrager verbunden werden. Der Kern kann hierbei aus zwei Hälften gebildet werden, die beispielsweise verklebt und/oder geklammert werden, um eine mechanische Stabilität zu gewährleisten,

In US 2011/0095620 A1 wird ein planarer Übertrager für miniaturisierte Anwendungen beschrieben mit zwei Windungen, die auf gegenüberliegenden Seiten eines isolierenden Substrates liegen. Das physikalische Grundprinzip der übertragung von Energie bzw. Daten beruht auf Induktion. Es handelt sich hierbei jedoch um keinen eigensicheren Übertrager, wobei auch kein magnetischer Kern verwendet wird.

In EP 0 715 322 A1 ist ein Übertrager bzw. Transformator beschrieben, dessen Leiterbahnen vollständig in Planartechnik mit Lagenaufbau gefertigt ist, bei dem die Leiterbahnen in einer zu einem Stück zusammengefügten Leiterplatte untergebracht sind. Die Leiterplatte wird von einem geschlossenen Magnetkern umgeben.

US 5 353 001 A zeigt einen planaren Übertrager mit einem magnetischen Kern und spiralförmigen Windungen, der eine Beschichtung als Isolation zwischen Windungen und dem Kern aufweist.

WO 2004/040599 A1 zeigt einen planaren Transformator mit nebeneinander angeordneten Primär- und Sekundärwicklungen, bei dem oberhalb der Wicklungen der Stromkreisen keine Isolationsschicht zwischen den Stromkreisen und dem Kern vorgesehen ist.

GB 2 355 343 A zeigt einen Übertrager, der einen magnetischen Kern aufweist, der über eine Luftstrecke gegenüber den Windungen isoliert ist.

DE 296 11 276 U1 zeigt einen Planartransformator mit jeweils auf einer Primärplatine bzw. auf einer Sekundärplatine aufgebrachten Primär- bzw. Sekundärwicklungen, wobei über den jeweiligen die Wicklungen bildenden Leiterbahnen eine Isolationsfolie aufgebracht ist.

Es ist eine Aufgabe der vorliegenden Erfindung, Miniaturisierungsmöglicchkeiten der oben beschriebenen planaren Übertrager vorzuschlagen, insbesondere eine Miniaturisierung von eigensicheren planaren Übertragern zu ermöglichen.

Diese Aufgabe wird erfindungsgemäß durch die Merkmale des Patentanspruches 1 gelöst. Weitere Ausgestaltungen ergeben sich aus den Unteransprüchen.

Erfingdungsgemäß wird ein planarer eigensicherer Übertrager mit einer vertikalen Ausdehnung und einer horizontalen Ausdehnung bereitgestellt. Der Übertrager weist einen Schichtaufbau mit einer Mehrzahl von Stromkreisen auf, wobei ein erster Stromkreis und ein zweiter Stromkreis galvanisch voneinander getrennt sind. Ferner weist der Übertrager mindestens einen magnetischen Kern auf, der zumindest teilweise den Schichtaufbau umschließt und zumindest auf den ersten Stromkreis und auf den zweiten Stromkreis wirkt, wobei der erste Stromkreis und der mindestens zweite Stromkreis im Wesentlichen in einer Ebene liegen und eine Schicht des Schichtaufbaus bilden.

Die Stromkreise können innerhalb der Isolierschichten auch auf verschiedenen Zwischenlagen unterschiedlich ausgebildet sein, so dass die Stromkreise innerhalb der Isolierschichten, welche in einer gemeinsamen Dimension, beispielsweise in horizontaler Richtung ausgebildet sind, weiterhin im Wesentlichen in einer Ebene liegen und eine Schicht des Schichtaufbaus bilden, ohne dass sie elektrisch miteinander in Kontakt kommen.
Der erfindungsgemäße Übertrager oder Transformator kann alle der Norm DIN EN 60079-11 nach geforderten Sicherheitsabstände erfüllen und bietet gleichzeitig die Funktionalität hinsichtlich Energie- und/oder Daten- bzw. Signalübertragung.

Erfindungsgemäß wird die Gesamtdicke eines Übertragers verringert oder minimiert. Dies ist vor allem von Vorteil, wenn die Übertrager in schmale Gehäuse integriert werden sollen, die beispielsweise eine Gesamtdicke von ca. 6 mm aufweisen und wenn innerhalb des Gehäuses maximal etwa 4,5 mm Platz zur Verfügung steht. Somit ist es ein besonderer Vorteil der Erfindung einen eigensicheren Übertrager bereitstellen zu können, der eine Gesamtdicke von beispielsweise 4,5 mm nicht übersteigt. Ein Vorteil der Erfindung ist es, dass die Bauhöhe des eigensicheren Übertragers bei gleich bleibenden oder nur gering vergrößerten horizontalen Abmessungen verringert wird.

Gemäß einem Ausführungsbeispiel des erfindungsgemäßen Übertragers ist eine Gesamthöhe des Übertragers das Vierfache eines gesamten Isolationsabstands einer Mindestisolationsdicke T0.

Erfindungsgemäß wird eine Auslegung der erforderlichen Isolation für einen eigensicheren Betrieb so dimensioniert, dass N-1 Isolationsdicken nun auf die horizontale Ausdehnung des erfindungsgemäßen Übertragers verlagert werden, wobei N die Anzahl der verwendeten Stromkreise ist.

Bei der Verlagerung der Stromkreise in horizontaler Ausdehnung nebeneinander ist darauf zu achten, dass keiner der Stromkreise näher an eine andere Potentialgruppe kommt als zulässig, dies gilt insbesondere auch für den magnetischen Kern.

Gemäß einer Ausführungsform des erfindungsgemäßen Übertragers kann vorgesehen werden, dass eine Gesamtisolationsdicke in vertikaler Ausdehnung des Übertragers 1 x T0 beträgt, wobei T0 ein Mindestisolationsabstand ist. Somit wird einmal T0 benötigt anstelle von N x T0 bei herkömmlichen Übertragern, wobei N die Anzahl der sicher galvanisch voneinander getrennten Stromkreise ist.

Gemäß einer Ausführungsform des erfindungsgemäßen Übertragers ist bei einer geforderten Mindestisolationsdicke T0 einer Isolationsschicht von etwa 1 mm die Gesamtdicke des Übertragers nicht wesentlich größer als etwa 4 mm. Bei der Gesamtdicke des Übertragers werden Dicken von Leiterbahnen, Isolationsmaterialien, Ferriten, Lacken, etc. berücksichtigt.

Auch kann die Geometrie der magnetischen Kerne bzw. Kernteile derart optimiert oder minimiert werden, so dass der Platzbedarf minimal wird und die geometrische Form der Kerne bzw. Kernteile möglichst einfach wird. Dies steht in Einklang zu einer geforderten Kostenoptimierung von Elektronikgeräten, die eigensichere Übertrager beinhalten.

Einige Ausführungsbeispiele der Erfindung sind in den Zeichnungen rein schematisch dargestellt und werden nachfolgend näher beschrieben. Es zeigt:
- Fig. 1: eine schematische Darstellung eines herkömmlichen Übertragers mit zwei Stromkreisen;
- Fig. 2: eine schematische Darstellung eines herkömmlichen Übertragers mit drei Stromkreisen;
- Fig. 3: eine schematische Darstellung eines Übertragers mit zwei Stromkreisen gemäß eines Ausführungsbeispiels der Erfindung;
- Fig. 4: eine schematische Darstellung eines Übertragers mit drei Stromkreisen gemäß eines Ausführungsbeispiels der Erfindung; und
- Fig. 5 und Fig. 6: jeweils eine schematische Darstellung in zwei verschiedenen Explosionsansichten eines Übertragers mit zwei Stromkreisen gemäß eines weiteren Ausführungsbeispiels der Erfindung.

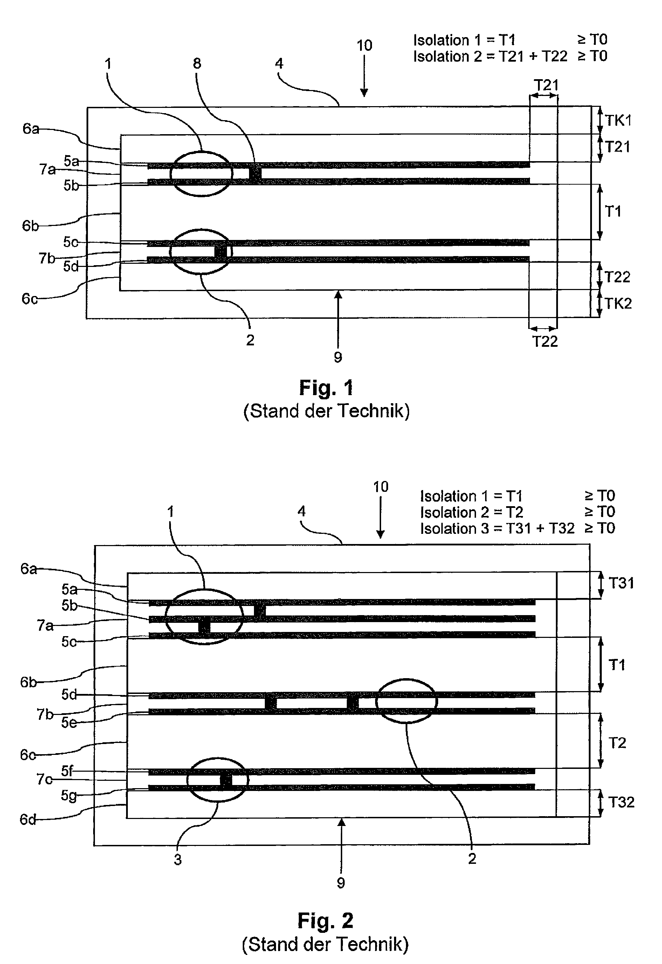

Fig. 1 zeigt eine schematische Darstellung eines herkömmlichen Übertragers 10 mit einem ersten Stromkreis 1 und einem zweiten Stromkreis 2. Der Übertrager 10 ist als eigensicher Leiterplattenübertrager ausgebildet, ähnlich wie der Leiterplattenübertrager wie beispielsweise in EP 0 715 322 A1 beschrieben. Der Übertrager 10 weist einen Lagenaufbau mit Primär- und einer Sekundärseite auf, die jeweils durch die beiden Stromkreise 1, 2 gebildet werden. Durch eine induktive Kopplung der beiden Stromkreise 1, 2 wird der Übertrager bzw. Transformator bei gleichzeitig galvanischer Trennung der Stromkreise 1, 2 gebildet.

Fig. 1 zeigt einen Querschnitt durch eine Leiterplatte 9 oder Leiterplattenanordnung 9, die von einem Kern 4 umschlossen ist, wobei der Kern 4 die Leiterplatte 9 an mehreren Stellen durchstößt. Das Durchstoßen kann beispielsweise durch Fräsungen in der Leiterplatte 9 bereitgestellt werden kann. Die Leiterplatte 9 weist mehrere Lagen auf, die sich aus Schichten von Leiterbahnen 5a bis 5d und Isolationsschichten 6a bis 6c sowie 7a bis 7b zusammensetzt. In diesem speziellen Lagenaufbau können die Isolationsschichten unterteilt werden in solche (6a bis 6c), die die einzelnen Stromkreise 1, 2 voneinander trennen und solche (7a bis 7b), die innerhalb der einzelnen Stromkreise für eine Isolierung sorgen. Die Isolationsschichten 7a bis 7b ermöglichen vielfältige Leiterstrukturen, wie beispielsweise spiralförmige Windungen auf der Lage 5a, die mit einem Rückleiter auf der Lage 5b versehen werden können. Die Lagen innerhalb eines Stromkreises können mit einer elektrischen Kontaktierung 8 wie beispielsweise einer Durchlochkontaktierung verbunden werden.

In dem Lagenaufbau des eigensicheren Transformators aus Fig. 1 sind die beiden Stromkreise 1, 2 bzw. Potentialgruppen 1, 2 über eine erste feste Isolation oder Feststoffisolation der Dicke T1 (Isolation 1) galvanisch voneinander getrennt. Hierbei ist die Isolationsdicke T1 größer oder gleich dem für die Schutzklasse geforderten Schutzniveau, was eine notwendige Bedingung für einen eigensicheren Übertrager ist. Das geforderte Schutzniveau entspricht somit dem Mindestisolationsabstand T0, auch als geforderte Isolationsdicke oder Mindestisolationsdicke bezeichnet. Da der Kern 4 als leitender Körper betrachtet wird, muss neben der benötigten ersten Isolation zwischen der Primär- und Sekundärseite (Isolation 1) auch eine zweite Isolation zwischen den einzelnen Windungen der Stromkreise und dem Kern 4 sichergestellt werden (Isolation 2). Die zweite Isolation kann dabei in zwei Anteile T21 und T22 aufgeteilt werden, wobei die Summe aus den Dicken T21 und T22 der zweiten Isolation ebenfalls größer oder gleich der für die Schutzklasse geforderten Mindestisolationsdicke T0 ist. Beispielsweise weisen die beiden Anteile der zweiten Isolation eine gleiche Dicke auf.

Eine zusätzliche Nebenbedingung für die Auslegung eines Übertrages ist beispielsweise in DIN EN 60079-11 derart gefordert, dass keiner der beiden Anteile T21 und T22 einen Mindestanteil der gesamten zweiten Isolation, beispielsweise ein Drittel der zweiten Isolation, unterschreiten darf. In der Regel werden die beiden Anteile T21 und T22 aus Symmetriegründen identisch und gleich der Hälfte der ersten Isolation gewählt.

Der klassische Leiterplattenübertrager 10 ist mit einem magnetischen Kern 4 ausgestattet, um eine möglichst optimale magnetische Leitfähigkeit vereint mit einer maximalen Schirmwirkung zu erzielen. Hierbei umschließt der magnetische Kern 4 die Leiterplatte 9 oder Teile der Leiterplatte mit oder ohne einen Luftspalt und ist sowohl oberhalb als auch unterhalb der Leiterplatte 9 sowie jeweils seitlich der Leiterplatte 9 angeordnet. Da die herstellungsbedingten Dicken TK1 und TK2 des magnetischen Kerns 4 oberhalb und unterhalb der Leiterplatte 9 typischerweise größer als die geforderte Isolationsdicke T0 mit TK1, TK2 > T0 sind (wenn T0 beispielsweise 1 mm beträgt), ergibt sich eine Gesamtdicke des Leiterplattenübertragers 10 von mindestens viermal der Mindestisolationsdicke T0. Hierbei sind die Schichtdicken der Leiterbahnen (5a bis 5d) sowie die Dicken der zusätzlichen Isolationsschichten (7a bis 7b) noch nicht einbezogen.

Beträgt die geforderte Dicke der Isolationsschicht T0 beispielsweise 1 mm, so ist die Gesamtdicke des klassischen Leiterplattenübertragers 10 größer als 4 mm. In vielen Anwendungen beträgt die Dicke zwischen 6 mm und 12 mm bei einer Gesamtfläche von ca. 6 cm² bis 8 cm².

Fig. 2 zeigt eine schematische Darstellung eines herkömmlichen Übertragers 10 mit drei Stromkreisen 1, 2, 3. Fig. 2 verdeutlicht einen Lagenaufbau einer Leiterplatte 9 im Fall von drei sicher galvanisch getrennten Stromkreisen 1, 2, 3 als weitere Ausführungsvariante ausgehend von Fig. 1. Die Windungen des ersten Stromkreises 1 bzw. der ersten Potentialgruppe 1 sind in diesem Beispiel als drei Leiterbahnebenen 5a bis 5c ausgeführt, während die Windungen des Stromkreises 2 und des Stromkreises 3 jeweils mit zwei Leiterbahnebenen 5d und 5e bzw. 5f und 5g ausgeführt sind.

Als Folgerung aus dem vorangegangenen Konzept eines eigensicheren Betriebes müssen zur sicheren galvanischen Trennung aller drei Stromkreise 1, 2, 3 drei Isolationsschichten mit einer ersten Isolation (Isolation 1), einer zweiten Isolation (Isolation 2) und einer dritten Isolation (Isolation 3) verwendet werden, die jeweils größer oder gleich der Mindestisolationsdicke T0 gewählt werden müssen. Hierdurch vergrößert sich folglich die Gesamtdicke des Übertragers 10. Allgemein gilt, dass die Gesamtisolationsdicke bei N sicher galvanisch voneinander getrennten Stromkreisen mindestens N x T0 beträgt. Die Gesamtdicke des Übertragers 10 berücksichtigt weitere Schichtdicken, wie beispielsweise die Leiterbahnstärke 5a bis 5g und die weiteren Isolationsschichten 7a bis 7c.

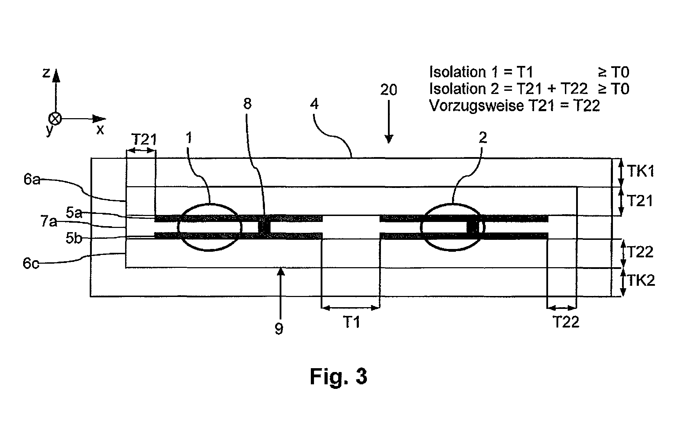

Fig. 3 zeigt eine schematische Darstellung eines Übertragers 20 gemäß eines Ausführungsbeispiels der Erfindung mit zwei Windungen bzw. einem ersten Stromkreis 1 und einem zweiten Stromkreis 2, die voneinander galvanisch getrennt sind. Eine erste Isolation (Isolation 1) mit der Isolationsdicke T1 befindet sich zwischen den einzelnen Stromkreisen 1, 2. Im Vergleich zu der Ausführungsform der Fig. 1 wird die erste Isolation (Isolation 1) aus der vertikalen Dimension in die horizontale Dimension verlagert. In diesem Zusammenhang bezeichnet die horizontale Dimension in allen Figuren die Erstreckung parallel zur Leiterplatte (als x-Richtung oder y-Richtung in Fig. 3 skizziert) und die vertikale Dimension die Erstreckung senkrecht zur Leiterplatte (z-Richtung in Fig. 3).

Die vorliegende Erfindung verwendet einen anderen Schichtaufbau oder eine andere Leiterplattenstruktur oder Leiterplattenschichtung im Vergleich zu den in Fig. 1 und Fig. 2 gezeigten herkömmlichen Ausführungsbeispielen. Wie beschrieben, beträgt bei den herkömmlichen Übertragern die Gesamtisolationsdicke mindestens N x TO, wobei N die Anzahl der sicher getrennten Stromkreise bezeichnet und T0 die dem Schutzniveau Rechnung getragene Mindestisolationsdicke in isolierendem Medium ist.

Durch die Nebeneinanderanordnung der Stromkreise 1, 2 kann die Gesamtdicke des erfindungsgemäßen Übertragers reduziert werden und die Gesamtisolationsdicke wird von mindestens N x T0 auf nunmehr nur noch auf mindestens 1 x T0 reduziert. Bei mehreren zu isolierenden Stromkreisen 1, 2, beispielsweise drei Stromkreisen 1, 2, 3, können auch diese weiteren Stromkreise in die horizontale Dimension verlagert werden.

Die Gesamtisolationsdicke reduziert sich auf 1 x T0 durch Verlagerung der Isolation zwischen den einzelnen Stromkreisen in die horizontale Dimension. Im Spezialfall von zwei (N = 2) zu isolierenden Stromkreisen wird die minimale Gesamtisolationsdicke von 2 x T0 auf 1 x T0 um einen Reduktionsfaktor von zwei reduziert. Allgemein ist der Reduktionsfaktor entsprechend N.

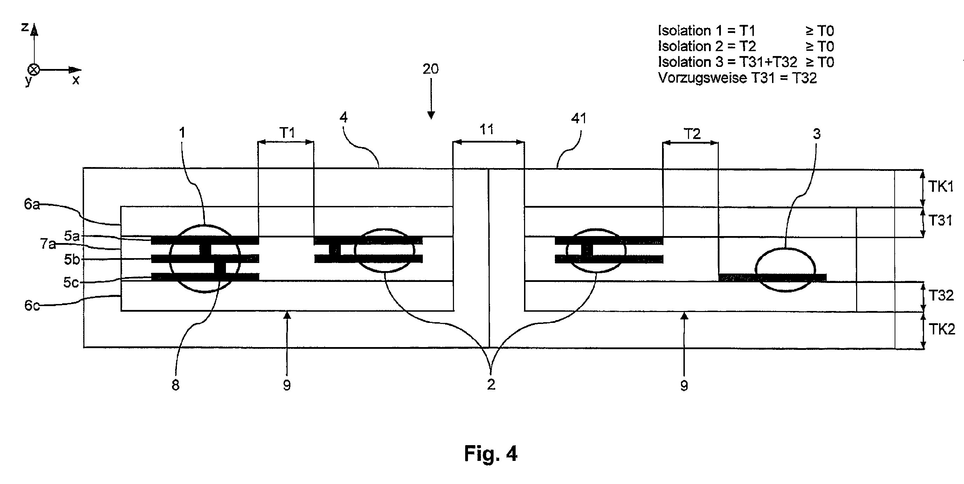

Fig. 4 zeigt eine schematische Darstellung eines Übertragers 20 gemäß eines Ausführungsbeispiels der Erfindung mit drei Windungen bzw. einem ersten Stromkreis 1, einem zweiten Stromkreis 2 und einem dritten Stromkreis, die voneinander galvanisch getrennt und erfindungsgemäß horizontal nebeneinander angeordnet sind. Die erste Windung 1 erstreckt sich über drei Lagen 5a bis 5c des Leiterplattenaufbaus 9, die zweite Windung 2 über zwei Lagen 5a und 5b und die dritte Windung 3 über eine Lage 5c.

Die Stromkreise in Fig. 4 sind untereinander durch die Isolationen T1 und T2 galvanisch voneinander getrennt und durch die Isolation 3 ebenfalls von dem magnetischen Kern. Der magnetische Kern ist in diesem Ausführungsbeispiel aus zwei Kernanteilen 4 und 41 gebildet, die nebeneinander angeordnet sind und die Leiterplattenanordnung 9 in dem Bereich 11 durchstoßen. Dabei kann der Stromkreis 2 beispielsweise den Bereich 11 umschließen und somit mit beiden Kernen 4 und 41 zusammenwirken. Obwohl die einzelnen Windungen bzw. Stromkreise 1, 2, 3 auf unterschiedlichen Lagen 5a bis 5c angebracht werden können, sind sie im Wesentlichen als horizontal nebeneinander zu betrachten, da die Isolationsschichten (Isolation 1, Isolation 2) in der horizontalen Dimension ausgebildet sind. Lediglich die dritte Isolation (Isolation 3), die die Stromkreise von den magnetischen Kernen 4, 41 trennt, erstreckt sich durch die beiden Mindestanteile T31 und T32 in die vertikale Dimension. Somit beträgt die Gesamtisolationsdicke auch bei drei sicher galvanisch zu trennenden Stromkreisen nur noch mindestens 1 x T0, wobei T0 wiederum die dem Schutzniveau Rechnung getragene Mindestisolationsdicke in isolierendem Medium ist.

Die horizontale Verlagerung der einzelnen Stromkreise und die damit einhergehende reduzierte Dicke oder reduzierte Ausdehnung in vertikaler Richtung des Übertragers 20 kann mit einem erhöhten Flächenbedarf in der horizontalen Dimension einhergehen.

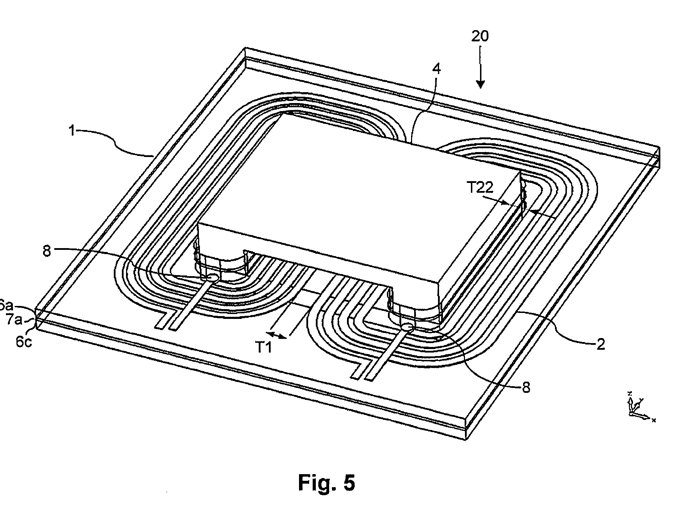

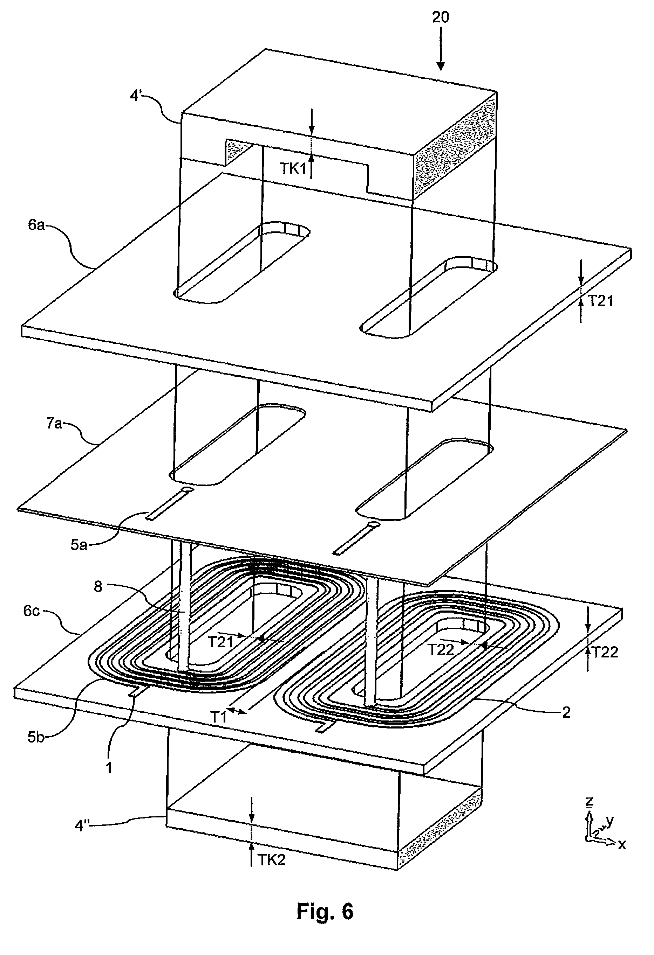

Ein weiteres Ausführungsbeispiel der Variante mit zwei Windungen ist in den Fig. 5 und Fig. 6 gezeigt.

In Fig. 5 sind die zwei galvanisch voneinander getrennten Stromkreise 1, 2 magnetisch mit jeweils einer Primärwindung und einer Sekundärwindung miteinander gekoppelt. Dazu sind Leiterbahnen der jeweiligen Potentialgruppe 1, 2 nebeneinander auf einem isolierenden Träger 6c aufgebracht und durch die Isolation T1 voneinander getrennt.

Die Windungen beider spiralförmiger Spulen sind auf einer elektrisch leitfähigen Lage 5b angebracht und die Rückleiter auf der Lage 5a. Die beiden Lagen sind an zwei Stellen über Verbindungselemente 8 elektrisch miteinander verbunden. Die dünne Isolierschicht 7a trennt die beiden elektrisch leitenden Lagen 5a und 5b voneinander. Der magnetische Kern 4 weist in diesem Ausführungsbeispiel zwei Teile auf, eine U-förmige Kernhälfte 4' und eine I-förmige Kernhälfte 4'', die beispielsweise miteinander verklebt oder geklammert werden können. Durch Aussparungen, beispielsweise Fräsungen, in der Leiterplatte können beide Kernhälften 4' und 4'' miteinander verbunden werden. Da der Kern als elektrisch leitfähig betrachtet werden kann, sollte eine angemessene Isolierung auch zwischen den einzelnen Stromkreisen 1, 2 und dem Kern 4 gewährleistet werden.

In Fig. 5 wird eine Isolierung einerseits durch die beiden Isolierschichten 6a mit der Dicke T21 und 6c mit der Dicke T22 realisiert. Andererseits ragen die Windungen der Stromkreise 1, 2 nicht bis zur Aussparung für den Kern 4 heran, wodurch ein Sicherheitsabstand zwischen den Windungen 1, 2 und dem Kern 4 von mindestens T21 bzw. T22 zu allen Seiten gegeben ist. Entsprechend der Fig. 3 setzt sich die Gesamtdicke des Übertragers 20 im Wesentlichen aus der Dicke der beiden Isolierschichten 6a und 6c und der Dicke der beiden Kernanteile TK1 und TK2 zusammen, wobei die Isolierschicht 7a wesentlich dünner ausfallen kann als die beiden Isolierschichten 6a, 6c.

In dem Ausführungsbeispiel der Fig. 5 und Fig. 6 beträgt die Gesamtdicke des Aufbaus etwa 4 mm in z-Richtung, während der Flächenbedarf bei etwa 20 mm in x-Richtung und etwa 19,5 mm in y-Richtung liegt, wobei die Koordinaten x und y jeweils eine horizontale Ebene in den Fig. 5 und Fig. 6 aufspannen.

Fig. 6 zeigt einen Lagenaufbau des eigensicheren Übertrages 20 aus Fig. 5 in einem auseinander gebauten Zustand. Der Übertrager 20 weist eine erste isolierende Lage 6a der Dicke T21, eine zweite isolierende Lage 7a und eine dritte isolierende Lage 6c der Dicke T22 auf. Auf der dritten Lage 6c ist der erste Stromkreis 1 und der zweite Stromkreis 2 zur Seite hin, die der zweiten Lage zugewandt ist, jeweils auf der Leiterbahnschicht 5b angeordnet. Stromkreise 1, 2 umschließen Hohlräume bzw. Aussparungen in die der magnetische Kern des Übertrages 20 eingreift. Hierbei weisen die Stromkreise 1, 2 jeweils Abstände T21, T22 in horizontaler Richtung zum magnetischen Kern auf. In vertikaler Richtung (z-Richtung) weist die dritte Lage 6c eine Dicke von T22 auf.

Durch eine Kombination einer U-förmigen magnetischen Kernhälfte 4' mit einer I-förmigen magnetischen Kernhälfte 4'' können beide Windungen 1 und 2 oder Stromkreise nebeneinander platziert werden. Durch den magnetischen Kern 4', 4'' kann eine hohe Kopplung zwischen den einzelnen Spulen 1, 2 gewährleistet werden. Die geometrische Form der Kernanteile 4', 4'' kann auf verschiedene Arten abgewandelt werden, so können beispielsweise zwei identische U-förmige magnetische Kernhälften miteinander verbunden werden. Auch abgerundete Strukturen sind denkbar.

### Bezugszeichenliste

- 1: Stromkreis bzw. Potentialgruppe
- 2: Stromkreis bzw. Potentialgruppe
- 3: Stromkreis bzw. Potentialgruppe
- 4: magnetischer Kern
- 4': erster Teil eines magnetischen Kerns
- 4'': zweiter Teil eines magnetischen Kerns
- 41: zweiter magnetischer Kern
- 5a bis 5g: Leiterbahnschichten
- 6a bis 6c: Isolationsschichten zwischen den Stromkreisen
- 7a bis 7b: Isolationsschichten innerhalb eines Stromkreises
- 8: elektrische Kontaktierung
- 9: Leiterplatte
- 10: herkömmlicher Übertrager bzw. Transformator
- 11: Bereich einer Aussparung in einer Leiterplatte
- 20: erfindungsgemäßer Übertrager bzw. Transformator
- T0: Mindestisolation / Schutzniveau / Isolationsdicke
- TK1: erste Dicke eines magnetischen Kerns
- TK2: zweite Dicke eines magnetischen Kerns
- T1: erste Isolationsdicke
- T2: zweite Isolationsdicke
- T21: Abstand / Isolationsdicke
- T22: Abstand / Isolationsdicke
- T31: Abstand / Isolationsdicke
- T32: Abstand / Isolationsdicke

## Patentansprüche

1. Planarer Übertrager (20) mit einer vertikalen Ausdehnung und einer horizontalen Ausdehnung aufweisend
einen Schichtaufbau mit einer Mehrzahl von Stromkreisen (1, 2, 3), wobei ein erster Stromkreis (1) und mindestens ein zweiter Stromkreis (2) galvanisch voneinander durch eine erste Isolation (T1) getrennt sind,
wobei der Schichtaufbau eine horizontale und eine vertikale Ausdehnung hat, wobei in vertikaler Ausdehnung eine Abfolge von isolierenden Lagen und leitenden Lagen vorgesehen ist,
mindestens einen magnetischen Kern (4), der zumindest teilweise den Schichtaufbau umschließt und zumindest auf den ersten Stromkreis (1) und auf den zweiten Stromkreis (2) wirkt,
wobei der erste und der zweite Stromkreis (1, 2) in dem Schichtaufbau in einer horizontalen Ausdehnung nebeneinander angeordnet sind, und der erste Stromkreis (1) und der zweite Stromkreis (2) im Wesentlichen in einer Ebene liegen und eine Schicht des Schichtaufbaus bilden, indem sich die Stromkreise (1, 2) vertikal über mindestens eine oder mehrere leitende Lagen erstrecken, getrennt durch vertikal übereinander angeordnete isolierende Lagen, wobei,
der planare Übertrager (20) ein eigensicherer Übertrager ist,
der erste Stromkreis (1) und der mindestens zweite Stromkreis (2) eine Mindestisolationsdicke T0 der ersten Isolation (T1) zueinander aufweisen, wobei die Mindestisolationsdicke T0 dem geforderten Schutzniveau des eigensicheren Übertragers (20) entspricht, und an keinem geometrischen Ort des Übertragers (20) die Mindestisolationsdicke T0 zwischen den Stromkreisen unterschritten wird,
wobei in horizontaler Schichtausdehnung der einzuhaltende Isolationsabstand durch die erste Isolation (T1) mit der Mindestisolationsdicke T0 des Isolationsmaterials der Isolationsschichten in horizontaler Erstreckung zwischen den nebeneinander angeordneten Stromkreisen (1, 2) bereitgestellt wird,
wobei in vertikaler Schichtausdehnung eine zweite Isolation (T21, T22) zwischen einzelnen Windungen der Stromkreise (1, 2) und dem magnetischen Kern (4) vorhanden ist und die Dicke der zweiten Isolation (T21, T22) einen ersten Anteil und einen zweiten Anteil aufweist und die Anteile insgesamt mindestens die Mindestisolationsdicke (T0) haben, und
wobei eine Gesamtisolationsdicke als Summe der Dicke von Isolationsschichten in vertikaler Ausdehnung des Übertrages (20) in den ersten Anteil und den zweiten Anteil aufgeteilt ist, wobei der erste Anteil in vertikaler Ausdehnung oberhalb der Schicht der Stromkreise (1, 2) liegt und wobei der zweite Anteil in vertikaler Ausdehnung unterhalb der Stromkreise (1, 2) liegt, wobei die Summe der Anteile größer oder gleich der Mindestisolationsdicke W0 ist.

2. Übertrager nach Anspruch 1, **dadurch gekennzeichnet, dass** der Schichtaufbau Schichten in horizontaler Ausdehnung verlaufend aufweist, wobei der erste Stromkreis (1) und der mindestens zweite Stromkreis (2) auf einer gemeinsamen horizontalen Schicht angeordnet sind.

3. Übertrager nach einem der Ansprüche 1 bis 2, **dadurch gekennzeichnet, dass**
die Gesamtisolationsdicke in vertikaler Ausdehnung des Übertragers (20) 1 x T0 beträgt,

4. Übertrager nach einem der Ansprüche 1 bis 3, **dadurch gekennzeichnet, dass** die Mindestisolationsdicke T0 in zwei gleiche Anteile der Gesamtisolationsdicke aufgeteilt wird.

5. Übertrager nach einem der Ansprüche 1 bis 3, **dadurch gekennzeichnet, dass** eine Aufteilung der Mindestisolationsdicke T0 auf den ersten Anteil und auf den zweiten Anteil der Gesamtisolationsdicke derart erfolgt, so dass kein Anteil ein Drittel der Dicke des Gesamtanteils, berechnet aus der Summe der beiden Anteile, unterschreitet.

6. Übertrager nach einem der Ansprüche 1 bis 5, **dadurch gekennzeichnet, dass**
leitende Schichten (5a, 5b) innerhalb des ersten Stromkreises (1) und des mindestens zweiten Stromkreises (2) ein oder mehrere Windungen einer Spule bilden, indem die leitenden Schichten (5a, 5b) des ersten Stromkreises (1) und des zweiten Stromkreises (2) jeweils mit einer elektrischen Verbindung (8) verbunden sind.

7. Übertrager nach einem der Ansprüche 1 bis 6, **dadurch gekennzeichnet, dass**
bei einer geforderten Mindestisolationsdicke T0 der Isolationsschicht (6) von etwa 1 mm eine Gesamtdicke des Übertragers (20) nicht mehr als etwa 4,5 mm beträgt, zumindest nicht wesentlich größer als etwa 4,5 mm ist.

8. Übertrager nach einem der Ansprüche 1 bis 7, **dadurch gekennzeichnet, dass**
die Mindestisolationsdicke T0 mindestens etwa 0,25 mm, vorzugsweise etwa 1 mm beträgt.

## Claims

1. A planar transducer (20) with a vertical extension and a horizontal extension having
a layer structure with a plurality of circuits (1, 2, 3), wherein a first circuit (1) and at least a second circuit (2) are galvanically isolated from one another by a first insulation (T1), wherein the layer structure has a horizontal and a vertical extension, wherein in vertical extension a sequence of insulating layers and conducting layers is provided,
at least one magnetic core (4), which at least partially encompasses the layer structure and acts at least on the first circuit (1) and on the second circuit (2),
wherein the first circuit (1) and the second circuit (2) are arranged In the layer structure next to one another in a horizontal extension, and the first circuit (1) and the second circuit (2) lie substantially in one plane and form a layer of the layer structure in that the circuits (1, 2) extend over at least one or more conducting layers, Isolated by vertical one upon the other arranged insulating layers, wherein
the planar transducer (20) is an intrinsically safe transducer (20), the first circuit (1) and the at least one second circuit (2) have a minimum insulation distance TO of the first insulation (T1) from one another, wherein the minimum insulation thickness TO corresponds the required protection level of the of the intrinsically safe transducer (20), and at no geometrical point of the transducer (20) is the insulation distance less than the minimum insulation distance TO between the circuits,
wherein in horizontal layer extension the Isolation distance to be complied with by the first insulation (T1) is provided with the minimum insulation distance TO of the insulation material of the insulation layers In horizontal extension between the next to one another arranged circuits (1, 2),
wherein in vertical layer extension a second insulation (T21, T22) between single windings of the circuits (1, 2) and the magnetic core (4) is provided and the thickness of the second insulation (T21, T22) has a First part and a second part and the parts altogether having at least the minimum insulation distance TO, and
wherein an overall insulation thickness as sum of the thickness of insulation layers In the vertical extension of the transducer (20) is divided into the first part and the second part, wherein the first part lies in the vertical extension above the layer of the circuits (1, 2), and wherein the second part lies in the vertical extension below the circuits (1, 2), wherein the sum of the parts Is greater than or equal to a minimum insulation thickness TO.

2. The transducer as claimed in claim 1, **characterized in that** the layer structure has layers running in the horizontal extension, wherein the first circuit (1) and the at least one second circuit (2) are arranged on a common horizontal layer.

3. The transducer as claimed in one of claims 1 to 2, **characterized in that** an overall insulation thickness in the vertical extension of the transducer (20) is 1 x TO.

4. The transducer as claimed In one of claims 1 to 3, **characterized In that** the minimum insulation thickness TO is divided into two equal parts of the overall insulation thickness.

5. The transducer as claimed in one of claims 1 to 3, **characterized in that** the minimum insulation thickness TO is divided into the first part and into the second part of the overall insulation thickness in such a way that no part is less than one-third of the thickness of the overall part calculated from the sum of the two parts.

6. The transducer as claimed in one of claims 1 to 5, **characterized In that** the conducting layers (5a, 5b) form one or more windings of a coil inside of the first circuit (1) and the at least second circuit (2) **In that** the conducting layers (5a, 5b) of the first circuit (1) and the second circuit (2) each are connected by means of an electrical connection (8).

7. The transducer as claimed in one of claims 1 to 6, **characterized in that** for a required minimum Insulation thickness TO of the insulation layer (6) of about 1 mm an overall thickness of the transducer (20) is not more than about 4.5 mm, at least not significantly greater than about 4.5 mm.

8. The transducer as claimed In one of claims 1 to 7, **characterized in that** the minimum insulation thickness TO is at least about 0.25 mm, preferably about 1 mm.

## Revendications

1. Transformateur planaire (20) comprenant une dimension verticale et une dimension horizontale comportant :
une structure stratifiée présentant une pluralité de circuits (1, 2, 3), un premier circuit (1) et au moins un deuxième circuit (2) étant séparés de manière galvanique l'un de l'autre par une première isolation (T1),
la structure stratifiée présentant une dimension horizontale et une dimension verticale, une succession de couches isolantes et de couches conductrices étant prévue dans la dimension verticale,
au moins un noyau magnétique (4), qui entoure au moins en partie la structure stratifiée et agit au moins sur le premier circuit (1) et sur le deuxième circuit (2),
le premier et le deuxième circuit (1, 2) étant juxtaposés dans la structure stratifiée dans une dimension horizontale, et le premier circuit (1) et le deuxième circuit (2) étant situés sensiblement dans un plan et formant une couche de la structure stratifiée, par le fait que les circuits (1, 2) s'étendent verticalement au-dessus d'au moins une ou plusieurs couches conductrices, séparées par des couches isolantes superposées verticalement,
le transformateur planaire (20) étant un transformateur à sécurité intrinsèque,
le premier circuit (1) et l'au moins un deuxième circuit (2) présentant une épaisseur d'isolation minimale T0 de la première isolation (T1) l'un par rapport à l'autre, l'épaisseur d'isolation minimale TO correspondant au niveau de protection exigé du transformateur à sécurité intrinsèque (20), et une valeur inférieure à l'épaisseur d'isolation minimale TO entre les circuits n'étant atteinte en aucun emplacement géométrique du transformateur (20),
dans lequel, dans la dimension horizontale de la couche, l'écart d'isolation devant être conservé est fourni par la première isolation (T1) présentant l'épaisseur d'isolation minimum TO du matériau d'isolation des couches d'isolation dans l'étendue horizontale entre les circuits (1, 2) juxtaposés,
dans lequel, dans la dimension verticale de la couche, une deuxième isolation (T21, T22) est présente entre les différents enroulements des circuits (1, 2) et le noyau magnétique (4), et l'épaisseur de la deuxième isolation (T21, T22) présente une première partie et une deuxième partie et les parties présentent dans l'ensemble au moins l'épaisseur d'isolation minimale (T0), et
dans lequel, une épaisseur d'isolation totale en tant que somme de l'épaisseur des couches d'isolation dans la dimension verticale du transformateur (20) est divisée en la première partie et en la deuxième partie, la première partie étant située dans la dimension verticale au-dessus de la couche des circuits (1, 2) et la deuxième partie étant située dans la dimension verticale au-dessous des circuits (1, 2), la somme des parties étant supérieure ou égale à l'épaisseur d'isolation minimale T0.

2. Transformateur selon la revendication 1, **caractérisé en ce que** la structure stratifiée présente des couches s'étendant dans la dimension horizontale, le premier circuit (1) et l'au moins un deuxième circuit (2) étant agencés sur une couche horizontale commune.

3. Transformateur selon l'une quelconque des revendications 1 à 2, **caractérisé en ce que** :
l'épaisseur d'isolation totale dans la dimension verticale du transformateur (20) atteint 1 × T0.

4. Transformateur selon l'une quelconque des revendications 1 à 3, **caractérisé en ce que** l'épaisseur d'isolation minimale T0 est divisée en deux parties identiques de l'épaisseur d'isolation totale.

5. Transformateur selon l'une quelconque des revendications 1 à 3, **caractérisé en ce qu'**une division de l'épaisseur d'isolation minimale T0 en la première partie et en la deuxième partie de l'épaisseur d'isolation totale est réalisée de telle manière qu'aucune partie n'est inférieure à un tiers de l'épaisseur de la partie totale, calculé à partir de la somme des deux parties.

6. Transformateur selon l'une quelconque des revendications 1 à 5, **caractérisé en ce que** :
les couches conductrices (5a, 5b) à l'intérieur du premier circuit (1) et de l'au moins un deuxième circuit (2) forment un ou plusieurs enroulements d'une bobine, par le fait que les couches conductrices (5a, 5b) du premier circuit (1) et du première circuit (2) sont reliées chacune à une liaison électrique (8).

7. Transformateur selon l'une quelconque des revendications 1 à 6, **caractérisé en ce que** :
lorsque l'épaisseur d'isolation minimale T0 exigée de la couche d'isolation (6) est de sensiblement 1 mm, une épaisseur totale du transformateur (20) n'atteint pas plus d'environ 4,5 mm, n'est tout du moins pas sensiblement supérieure à environ 4,5 mm.

8. Transformateur selon l'une quelconque des revendications 1 à 7, **caractérisé en ce que** :
l'épaisseur d'isolation minimale T0 atteint au moins environ 0,25 mm, de préférence environ 1 mm.
